Europäisches Patentamt

European Patent Office

Office européen des brevets

(19)

(11) **EP 0 626 728 B1**

(12) **FASCICULE DE BREVET EUROPEEN**

(45) Date de publication et mention
de la délivrance du brevet:
**04.10.2001 Bulletin 2001/40**

(51) Int Cl.$^7$: **H01L 27/07**, H03B 5/24

(21) Numéro de dépôt: **94401162.6**

(22) Date de dépôt: **25.05.1994**

(54) **Circuit integré du type à résistance, capacité et transistor, procédé de fabrication d'un tel circuit intégré et application à un oscillateur**

Integrierte Schaltung mit Widerständen, Kondensatoren und Transistoren, Herstellungsverfahren einer solchen Schaltung und Anwendung in einem Schwingkreis

Integrated circuit of the type comprising a resistor, capacitor and transistor, method of fabricating the same and application to an oscillator

(84) Etats contractants désignés:
**DE FR GB IT**

(30) Priorité: **28.05.1993 FR 9306481**

(43) Date de publication de la demande:
**30.11.1994 Bulletin 1994/48**

(73) Titulaire: **STMicroelectronics S.A.**
**94250 Gentilly (FR)**

(72) Inventeurs:
• **Fournel, Richard**
**F-94230 Cachan (FR)**

• **Tailliet, François**
**F-94230 Cachan (FR)**

(74) Mandataire: **Schmit, Christian Norbert Marie et al**
**Cabinet BALLOT-SCHMIT,**
**16, avenue du Pont Royal**
**94230 Cachan (FR)**

(56) Documents cités:
**FR-A- 1 424 482** **US-A- 3 471 755**

• **Semiconductor Devices Physics & Technology S.M.Sze pub. J.Wiley 1985, pgs. 481-485**

**Description**

L'invention concerne un circuit intégré de type à résistance, capacité et transistor. Elle trouve notamment une application dans les oscillateurs.

Les circuits de type RC sont utilisés notamment dans les oscillateurs à relaxation. Ces oscillateurs comportent en effet une capacité que l'on charge au moyen d'une résistance et que l'on décharge au moyen d'un transistor. Les grandeurs de ces trois éléments discrets influent directement sur les temps de charge et décharge de la capacité. Notamment, plus la capacité est grande, plus la décharge est lente et plus le transistor de décharge doit être large pour que la décharge se fasse le plus rapidement possible. En pratique, la décharge est très dépendante des caractéristiques des éléments discrets (capacité, transistor). Avec les technologies actuelles, la décharge nécessite ainsi au minimum de 2 à 5 nanosecondes pour des capacités très grandes de l'ordre de 10 pF ($10.10^{-12}$ farads). Or, les temps de charge et de décharge influent de manière directe sur la fréquence que l'oscillateur à relaxation permet d'obtenir. La fréquence est donc elle aussi dépendante des caractéristiques des éléments discrets de charge et décharge et le temps de décharge minimum de la capacité limite la fréquence. Avec les technologies actuelles, on obtient ainsi au maximum 10 à 20 mégahertzs en sortie d'un oscillateur à relaxation.

Des fréquences d'oscillation plus grandes sont pourtant recherchées dans certaines applications, et notamment pour les microprocesseurs. Un autre circuit est décrit dans US-A-3471755.

L'invention a pour objet une structure de circuit intégré à résistance, capacité et transistor qui permet une décharge plus rapide et indépendante des grandeurs de la résistance et de la capacité. Pour une technologie donnée, on a un temps de décharge très petit et fixe, quelle que soit notamment la valeur de la capacité.

La structure de l'invention est par ailleurs avantageusement compacte.

Telle que revendiquée, l'invention concerne un circuit intégré comportant un substrat ou un caisson d'un premier type (P) de dopage et dans ce substrat ou ce caisson :

- une première diffusion de dopage d'un second type ($N^+$) en forme de barreau de longueur Lb et de largeur e, pourvue en ses deux extrémités d'une première borne A et d'une deuxième borne B de connexion;
- une plaque de polysilicium qui recouvre le barreau et comportant un prolongement qui forme une troisième borne D de connexion;
- une deuxième diffusion de dopage du second type ($N^{++}$), auto-alignée par la plaque de polysilicium et pourvue d'une quatrième borne F de connexion;

le circuit intégré ainsi constitué formant un quadripôle A,B,D,F du type à résistance, capacité et transistor.

La première forme de barreau pourra être linéaire, repliée en serpentin, ou enroulée en hélice selon l'encombrement et la longueur recherchée.

L'invention concerne aussi le procédé de fabrication d'un quadripôle du type à résistance, capacité et transistor qui comporte principalement :

- la réalisation d'un barreau de diffusion de dopage élevé d'un deuxième type;
- la formation d'un oxyde de grille dans une fenêtre plus large que le barreau, délimitée par de l'oxyde épais;
- le recouvrement du barreau par une plaque de polysilicium;
- la réalisation d'une diffusion de dopage du même type que celui du barreau, cette diffusion étant auto-alignée par la plaque de polysilicium et délimitée par l'oxyde épais;
- la connexion de chaque extrémité du barreau à une première borne A et une deuxième borne B de connexion;
- la connexion de la plaque de polysilicium à une troisième borne de connexion D;
- la connexion de la diffusion auto-alignée à une quatrième borne de connexion F.

Le circuit obtenu est un quadripôle qui peut être avantageusement utilisé dans un oscillateur à relaxation. Un tel oscillateur comportera de préférence:

- un quadripôle A,B,D,F selon l'invention;
- un transistor de charge Tp mis en série entre une tension de charge Vcc et la borne A du quadripôle, avec sa grille connectée à la borne D du quadripôle;
- un étage de sortie ayant son entrée connectée à la borne B du quadripôle et sa sortie connectée à la borne D du quadripôle,

cet étage de sortie fournissant un premier état logique en sortie pour une tension en entrée supérieure à un premier seuil et un deuxième état logique en sortie pour une tension en entrée inférieure à un deuxième seuil.

D'autres caractéristiques et avantages de l'invention sont détaillés dans la description qui suit, faite en référence aux dessins annexés dans lesquels :

- la figure 1a représente un circuit quadripôle selon l'invention;
- la figure 1b représente une variante d'un circuit selon l'invention;
- la figure 1c représente une autre variante d'un circuit selon l'invention;
- la figure 2 représente en coupe différentes étapes a) à f) de fabrication d'un circuit selon l'invention;
- la figure 3 est un modèle électronique approximé du quadripôle de l'invention et

- la figure 4 représente un circuit oscillateur à relaxation utilisant le quadripôle de l'invention.

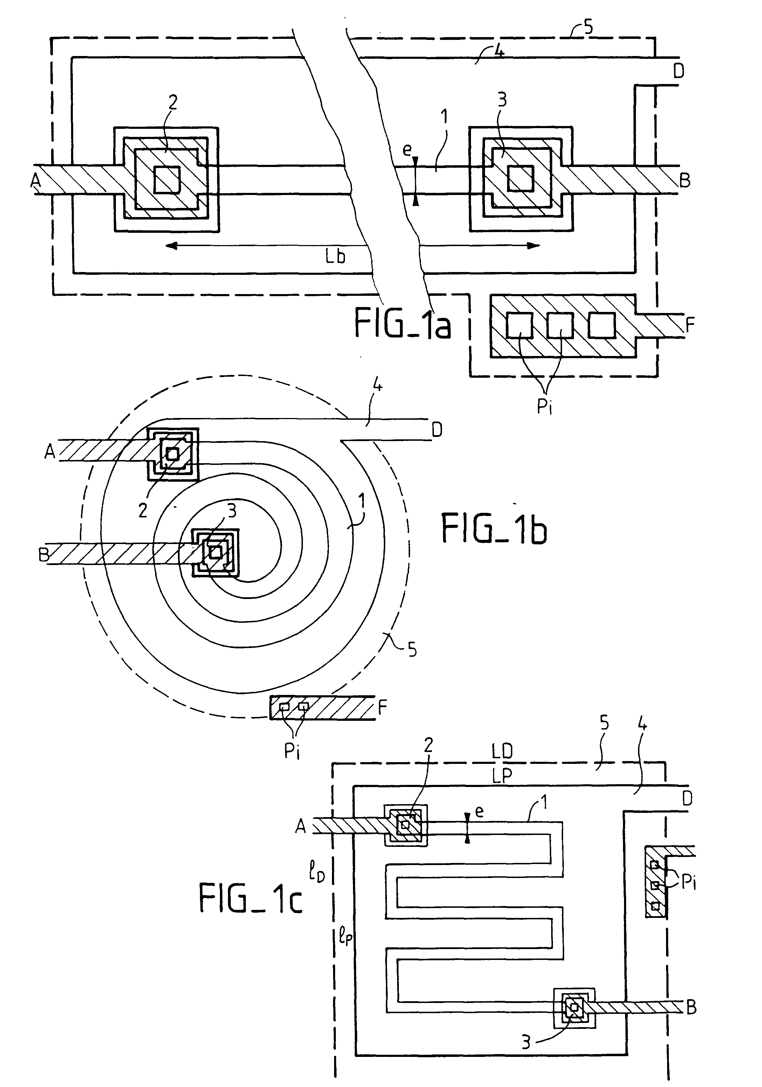

Le circuit de l'invention comme représenté en figures 1a, 1b, 1c comporte principalement :

- une première diffusion N+ en forme de barreau 1 de longueur Lb et de largeur e, réalisée dans un substrat P. Les deux extrémités du barreau sont référencées 2, 3.
- Une plaque 4 de polysilicium qui recouvre le barreau 1 de diffusion.
- Une deuxième diffusion N++ référencée 5, auto-alignée par la plaque de polysilicium. on a alors de manière classique un oxyde mince (non représenté) sous la plaque de polysilicium et sur la diffusion auto-alignée.

Le barreau 1 de diffusion N peut être linéaire (figure 1a), mais aussi enroulé en hélice (figure 1b) ou bien encore replié en serpentin (figure 1c). La forme du barreau dépend essentiellement de la longueur Lb envisagée pour le barreau et de l'espace disponible pour réaliser le circuit : les formes repliées ou enroulées offrent une bien meilleure compacité que la forme linéaire.

Les extrémités 2, 3 du barreau sont raccordées à des bornes de connexion A, B.

Dans un exemple représenté, le raccordement des deux extrémités du barreau est réalisé en métal. A cet effet deux ouvertures sont prévues dans la plaque de polysilicium, à l'endroit des deux extrémités 2, 3 du barreau 1 et par lesquelles la métallisation est effectuée. Les métallisations forment un ruban dans un plan supérieur parallèle à la plaque de polysilicium.

Mais le raccordement pourrait se faire par exemple avec un deuxième niveau de polysilicium (circuits multi-poly).

La plaque 4 de polysilicium est du type rectangulaire (voir carrée), comme représenté sur la figure 1c, ou bien encore circulaire (figure 1b). Elle est connectée à une troisième borne de connexion D. Dans l'ensemble représenté, la plaque est pourvue d'un prolongement en forme de ruban dans le plan de la plaque, qui constitue cette troisième borne de connexion D du circuit (figure 1a, 1b, 1c). Mais on pourrait aussi contacter le polysilicium à une métallisation pour former cette troisième borne (non représenté).

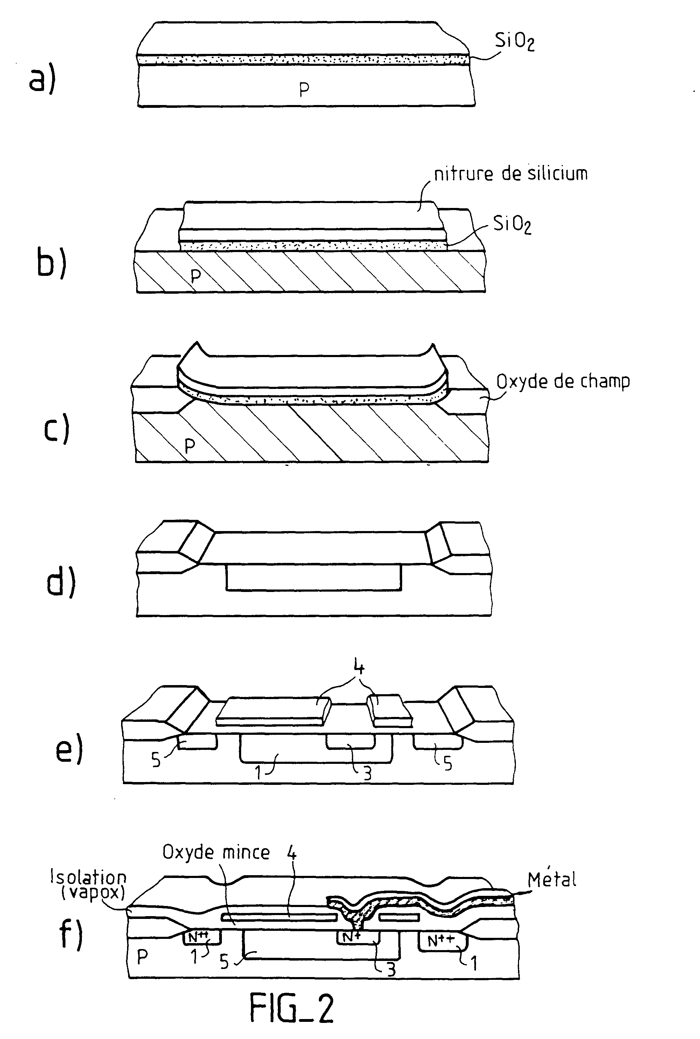

La diffusion 5 auto-alignée est, elle aussi, raccordée à une borne F de connexion. Dans l'exemple (figure 1c), ce raccordement est réalisé par une métallisation qui vient en vertical (figure 2, étape f) de préférence en plusieurs points Pi, sur la diffusion 5, à partir d'un plan supérieur parallèle à la plaque de polysilicium, plan dans lequel elle forme un ruban qui constitue la borne de connexion F.

Dans le cas où les raccordements sont des métallisations, les bornes de connexion peuvent être toutes dans le même plan de métallisation au-dessus de la plaque de polysilicium (comme représenté) ou dans des plans différents (circuit à plusieurs couches de métallisation).

Le procédé de fabrication de ce circuit nécessite principalement, pour un substrat de type P :

- la réalisation d'un barreau de diffusion de type N selon un procédé non auto-aligné ;
- la formation d'un oxyde de grille dans une fenêtre plus large que le barreau, délimitée par de l'oxyde épais;
- le recouvrement du barreau par une plaque de polysilicium;
- la réalisation d'une diffusion de dopage du même type N que celui du barreau, cette diffusion étant auto-alignée par la plaque de polysilicium et délimitée par l'oxyde épais,
- la connexion de chaque extrémité 2, 3 du barreau 1 à une première borne A et une deuxième borne B de connexion;
- la connexion de la plaque de polysilicium à une troisième borne de connexion D;
- la connexion de la diffusion auto-alignée à une quatrième borne de connexion F.

Le procédé comportera ainsi de manière classique par exemple, en technologie MOS à substrat P, les principales étapes suivantes (figure 2) :

- oxydation thermique du silicium (étape a);
- dépôt d'une couche de nitrure de silicium et gravure du nitrure et de l'oxyde (étape b);
- implantation ionique d'isolation de type P (Bore);
- croissance d'oxyde pour former l'oxyde de champ épais (étape c) ;
- retrait du nitrure;
- retrait de l'oxyde mince;
- masquage et implantation ionique de type N (Arsenic) pour former le barreau 1 de diffusion non auto-alignée (étape d);
- croissance de l'oxyde de grille;
- dépôt d'une couche de polysilicium et dopage de type N (phosphore) du polysilicium;
- photolithographie et gravure du polysilicium pour former la plaque 4 (avec les ouvertures pour les contacts sur le barreau);
- implantation ionique source-drain de type N (Arsenic) pour former la diffusion auto-alignée 5 (étape e) ;
- réoxydation;
- dépôt d'une couche d'oxyde d'isolation (vapox);
- ouverture des contacts dans la couche d'oxyde d'isolation;
- dépôt d'une couche de métal;
- gravure du métal (étape f);
- dépôt d'une couche de passivation et gravure de la couche de passivation.

On peut très bien réaliser ce circuit à partir d'un substrat N ou bien encore dans un caisson.

Les dopages utilisés sont ceux des techniques classiques pour les différents types de diffusion.

Pour le barreau 1 réalisé selon un procédé non auto-aligné, par un exemple selon le procédé décrit ci-dessus et communément appelé procédé "capa-implant", on a typiquement un dopage d'impuretés de $10^{19}$cm$^{-3}$ ce qui permet d'avoir une résistivité par carreau de 100Ω. Des variantes de dopage sont possibles qui permettent d'augmenter la résistivité, jusqu'à un dopage de $10^{17}$cm$^{-3}$ qui permet d'obtenir une résistivité par carreau de 5 kilo-ohms.

Dans le procédé décrit, le barreau est moins dopé (N+) que la diffusion 5 auto-alignée (N$^{++}$). Mais ce n'est qu'un exemple de réalisation qui ne doit pas limiter la portée de l'invention. D'autres rapports de dopage sont possibles. Notamment, on peut avoir des dopages identiques pour le barreau 1 et la diffusion 5 auto-alignée.

Pour la diffusion 5 auto-alignée, on peut choisir un dopage typique de drain ou de source de transistor (implantation ionique à faible énergie à travers un oxyde de grille), soit un dopage de $10^{20}$cm$^{-3}$.

Le circuit obtenu est un quadripôle A, B, D, F du type à résistance, capacité et transistor. Mais ces éléments ne sont pas discrétisables, ou séparables : ils sont répartis tout au long du barreau de diffusion N.

Un modèle électronique équivalent devra comporter plusieurs étages élémentaires comportant chacun une résistance, une capacité et un transistor, caractérisés par des valeurs moyennes.

On peut estimer que trois ou quatre étages élémentaires permettent une couverture de 90% du fonctionnement réel d'un tel quadripôle.

La résistance répartie est formée par le barreau 1 de diffusion. Sa valeur dépend d'une part du procédé de fabrication utilisé (capa-implant par exemple) et du dopage choisi, ce qui fixe la résistivité par carreau du barreau. Elle dépend d'autre part de la surface réelle du barreau. On a en effet :

$$R = R_\square \cdot \frac{Lb}{e}$$

pour un barreau linéaire.

Des correctifs connus doivent être apportés dans le cas où la résistance est repliée en serpentin ou enroulée en hélice.

Dans le cas du procédé de fabrication décrit en relation avec la figure 2 avec un dopage de $10^{19}$ cm$^{-3}$, la résistance par carreau est de l'ordre de 100 Ω/$\square$.

La capacité répartie est formée de la capacité répartie C1 de jonction barreau/substrat ainsi que de la capacité répartie C2 barreau/polysilicium. La capacité totale équivalente C est donc :

C = C1(barreau/substrat) + C2(barreau/polysilicium).

Dans le cas particulier d'un transistor linéaire (figure la), le transistor réparti a notamment comme longueur minimum du canal, la longueur du barreau sous la plaque de polysilicium (Lb). La grille du transistor T réparti est formée par la plaque de polysilicium. Sa source est reliée à la borne F du quadripôle.

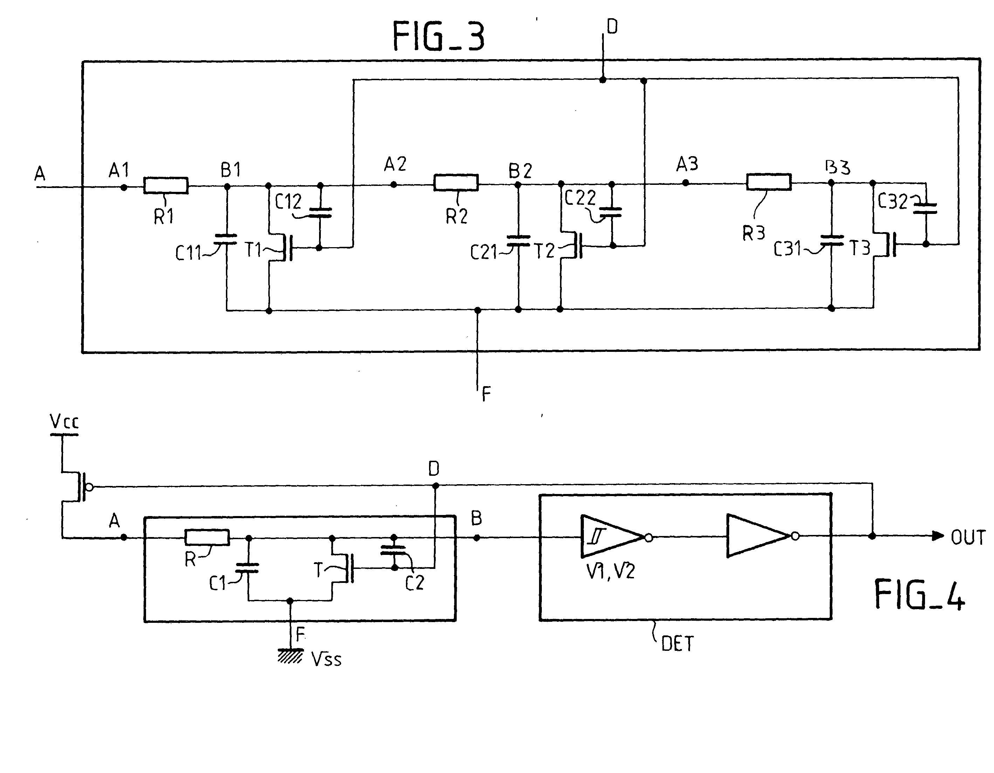

Dans le modèle électronique correspondant, comme représenté en figure 3 avec 3 étages E1, E2, E3 élémentaires, on a alors pour chaque étage Ei (i = 1, 2 ou 3) :

-   une résistance élémentaire Ri entre des noeuds Ai et Bi,
-   une capacité élémentaire $Ci_1$ de jonction barreau/substrat entre le noeud Bi et le substrat relié à la borne F,
-   un transistor Ti entre le noeud Bi et le substrat, dont la grille est reliée à la plaque de polysilicium (borne D du quadripôle) et
-   une capacité élémentaire $Ci_2$ barreau/polysilicium entre le noeud Bi et la grille du transistor (borne D du quadripôle).

Dans un exemple de réalisation du circuit selon la figure 1c, avec notamment les dimensions suivantes : pour le barreau :

e = 2 μm        dopage = $10^{-19}$cm$^3$
Lb = 250μm
$R_\square$ = 100Ω/$\square$

pour la plaque de polysilicium :

lp = 25 μm
$L_p$ = 260 μm

pour la diffusion auto-alignée :

ld = 30 μm
Ld = 270 μm

avec une capacité équivalente par carreau Ce de 1,5 farad/$\square$, donnée par
Ce=1,3(capacité C1)farad/$\square$ +0,2(capacité C2) farad/$\square$

On obtient: - une résistance répartie totale R de 31 kilo-ohms (en effectuant les correctifs dus à la forme de serpentin) et

-   une capacité répartie totale C de $0{,}750.10^{-12}$ farad (donnée par C = Ce x Lb x e), pour des dimensions totales du circuit qui sont faibles de l'ordre de 900 μm$^2$.

Le circuit est en effet compact, puisque les trois éléments résistance, capacité et transistor sont obtenus par la même structure et non par trois structures différentes. La compacité peut d'ailleurs être améliorée en utilisant des astuces de dessin comme montré par exemple sur la figure 1c, avec un décrochement dans le polysilicium au niveau de la métallisation de la diffusion 5 auto-alignée.

Une application immédiate d'un tel circuit est un oscillateur à relaxation comme représenté en figure 4. On a représenté le quadripôle A, B, D, F sous forme symbolique et en représentant un seul étage (R, C, T) du modèle électronique équivalent.

Un tel oscillateur comprendra typiquement :

- un transistor Tp de type P en série entre la tension de charge Vcc et la borne A du quadripôle, sa grille étant connectée à la borne D du quadripôle;
- un étage de détection de seuil DET comprenant au moins deux inverseurs, en série entre la borne D et la borne B du quadripôle et délivrant une sortie OUT. La borne F du quadripôle est reliée à la masse.

De préférence, un des inverseurs est un trigger de Schmitt avec un seuil V1 de basculement bas/haut différent du seuil V2 de basculement haut/bas.

Le fonctionnement est le suivant :

Lorsque la sortie du détecteur DET est à 0 volt (état logique bas ou zéro), on a alors :

- 0 volt sur la grille du transistor T réparti du quadripôle : il est bloqué;
- 0 volt sur la grille du transistor Tp de charge : il est donc passant et ramène la tension de charge Vcc sur la borne A du quadripôle : les capacités C1 et C2 formant la capacité répartie totale C se chargent à travers la résistance R répartie : la tension à la borne B monte et dépasse le seuil V1 bas/haut du détecteur qui bascule : sa sortie OUT passe à 5 volts (état logique haut ou "1"). On a donc 5 volts sur la borne D du quadripôle.

On a alors :

- 5 volts sur la grille du transistor Tp de charge; il est bloqué et la borne A est flottante.
- 5 volts sur la grille du transistor T réparti : il est passant. Les capacités C1 et C2 qui forment la capacité répartie totale C se déchargent à travers le transistor T réparti. La tension à la borne B du quadripôle diminue en-dessous du seuil V2 haut/bas du détecteur qui rebascule à zéro volt.

La décharge avec le circuit de l'invention est extrêmement rapide du fait que les éléments sont répartis tout au long du barreau. Si le barreau est long, la capacité est grande mais le transistor équivalent est aussi très large.

En pratique, quelles que soient les dimensions choisies pour le quadripôle, le temps de décharge est toujours le même, dans une technologie donnée (dopage), de l'ordre d'une nanoseconde. Dans l'exemple numérique pris pour le quadripôle, avec VCC égale à 5 volts, V1 de l'ordre de 4 volts et V2 de l'ordre de 1 volt, on a 45 nanosecondes de charge et 1 nanoseconde de décharge. Les dimensions R, C influent sur le temps de charge. Mais la décharge est en revanche indépendante des dimensions de R, C, T. On peut alors obtenir en sortie OUT un signal impulsionnel de fréquence élevée.

On peut ainsi obtenir en sortie d'un oscillateur à relaxation un signal impulsionnel de fréquence de l'ordre de 20 à 40 MHz, grâce au quadripôle de l'invention dont une caractéristique principale est le temps de décharge rapide de la capacité à travers le transistor, et indépendant des dimensions de la structure du quadripôle, par ailleurs très compacte.

**Revendications**

1. Circuit intégré du type comportant un substrat ou un caisson d'un premier type (P) de dopage et dans ce substrat ou ce caisson :

   - une première diffusion de dopage d'un second type ($N^+$) en forme de barreau (1) de longueur Lb et de largeur e, pourvue en ses deux extrémités (2,3) d'une première (A) et d'une deuxième (B) borne de connexion;
   - une plaque de polysilicium (4) qui couvre entièrement le barreau (1) à l'exception des bornes de connexion et comportant un prolongement qui forme une troisième borne (D) de connexion;
   - une deuxième diffusion (5) de dopage du second type ($N^{++}$) auto-alignée par la plaque de polysilicium (4) et pourvue d'une quatrième borne (F) de connexion; le circuit intégré ainsi constitué formant un quadripôle A,B,D,F du type à résistance, capacité et transistor.

2. Circuit intégré selon la revendication 1, **caractérisé en ce que** le barreau (1) est linéaire.

3. Circuit intégré selon la revendication 1, **caractérisé en ce que** le barreau (1) est enroulé en hélice.

4. Circuit intégré selon la revendication 1, **caractérisé en ce que** le barreau (1) est replié en serpentin.

5. Circuit intégré selon la revendication 1, **caractérisé en ce que** le barreau (1) est moins dopé ($N^+$) que la diffusion (5) auto-alignée ($N^{++}$).

6. Procédé de fabrication d'un circuit intégré dans un substrat ou un caisson d'un premier type de dopage **caractérisé en ce qu'**il comporte les étapes suivantes :

- la réalisation d'un barreau de diffusion non auto-alignée d'un deuxième type (1);
- la formation d'un oxyde de grille dans une fenêtre plus large que le barreau, délimitée par de l'oxyde épais;
- la réalisation d'une plaque de polysilicium (4) qui couvre entièrement le barreau de diffusion à l'exception des bornes de connexion;
- la réalisation d'une diffusion du deuxième type (5), cette diffusion étant auto-alignée par la plaque de polysilicium et délimitée par l'oxyde épais;
- la connexion de chaque extrémité du barreau à une première borne A et à une deuxième borne B de connexion;
- la connexion de la diffusion auto-alignée à une troisième borne de connexion (F);
- la connexion d'une quatrième borne (D) de connexion sur la plaque de polysilicium;
    pour former un quadripôle A, B, D, F du type à résistance, capacité et transistor.

7. Oscillateur à relaxation comportant :

- un quadripôle A, B, D, F selon la revendication 1
- un transistor de charge Tp mis en série entre une tension de charge Vcc et la borne A du quadripôle, avec sa grille connectée à la borne D du quadripôle;
- un étage de sortie DET avec au moins un seuil de détection, ayant son entrée connectée à la borne B du quadripôle et sa sortie OUT connectée à la borne D du quadripôle;

cet étage de sortie fournissant un premier état logique en sortie pour une tension en entrée supérieure au seuil de détection et deuxième état logique en sortie pour une tension en entrée inférieure au seuil de détection.

8. Oscillateur à relaxation selon la revendication 7, **caractérisé en ce que** l'étage de sortie à un premier seuil de tension bas/haut (V1) et un deuxième seuil de tension haut/bas (V2).

## Patentansprüche

1. Integrierte Schaltung der Art mit einem Substrat oder einer Senke einer Dotierung eines ersten Typs (P) und in diesem Substrat oder dieser Senke:

- einer ersten Diffundierung einer Dotierung eines zweiten Typs ($N^+$) in Form eines Stabs (1) einer Länge Lb und einer Breite e, der an seinen beiden Enden (2, 3) mit einer ersten (A) und einer zweiten Anschlußklemme (B) versehen ist;
- einer Platte aus Polysilicium (4), die den Stab (1) mit Ausnahme der Anschlußklemmen ganz bedeckt und eine Verlängerung aufweist, die eine dritte Anschlußklemme (D) bildet;
- einer zweiten Diffundierung (5) einer Dotierung des zweiten Typs ($N^{++}$), die gemäß der Platte aus Polysilicium (4) automatisch ausgerichtet wird und mit einer vierten Anschlußklemme (F) versehen ist;

wobei die so hergestellte integrierte Schaltung einen Vierpol A, B, D, F der Art mit Widerstand, Kondensator und Transistor bildet.

2. Integrierte Schaltung nach Anspruch 1, **dadurch gekennzeichnet, daß** der Stab (1) geradlinig ist.

3. Integrierte Schaltung nach Anspruch 1, **dadurch gekennzeichnet, daß** der Stab (1) spiralförmig aufgerollt ist.

4. Integrierte Schaltung nach Anspruch 1, **dadurch gekennzeichnet, daß** der Stab (1) schlangenförmig umgebogen ist.

5. Integrierte Schaltung nach Anspruch 1, **dadurch gekennzeichnet, daß** der Stab (1) weniger dotiert ist ($N^+$) als die automatisch ausgerichtete Diffundierung (5) ($N^{++}$).

6. Verfahren zur Herstellung einer integrierten Schaltung in einem Substrat oder einer Senke eines ersten Dotierungstyps, **dadurch gekennzeichnet, daß** es die folgenden Schritte aufweist:

- Herstellung eines Stabs (1) einer nicht automatisch ausgerichteten Diffundierung eines zweiten Typs,
- Bildung eines Gitteroxids in einem Fenster, das größer ist als der Stab und von dickem Oxid begrenzt wird;
- Herstellung einer Polysilicium-Platte (4), die den Diffundierungsstab mit Ausnahme der Anschlußklemmen vollständig bedeckt;
- Herstellung einer Diffundierung (5) des zweiten Typs, wobei diese Diffundierung gemäß der Polysilicium-Platte automatisch ausgerichtet und vom dicken Oxid begrenzt wird;
- Anschluß jedes Endes des Stabs an eine erste Anschlußklemme A und eine zweite Anschlußklemme B;
- Anschluß der automatisch ausgerichteten Diffundierung an eine dritte Anschlußklemme (F);
- Anschluß einer vierten Anschlußklemme (D) an die Polysilicium-Platte; zur Bildung eines Vierpols A, B, D, F des Typs mit Widerstand, Kondensator und Transistor.

7. Kipposzillator mit:

- einem Vierpol A, B, D, F gemäß Anspruch 1,
- einem Ladetransistor Tp, der in Reihe zwischen eine Ladespannung Vcc und die Klemme A des Vierpols geschaltet ist, wobei sein Gate an die Klemme D des Vierpols angeschlossen ist;
- einer Ausgangsstufe DET mit mindestens einer Erfassungsschwelle, deren Eingang an die Klemme B des Vierpols und deren Ausgang OUT an die Klemme D des Vierpols angeschlossen ist;

wobei diese Ausgangsstufe einen ersten logischen Zustand am Ausgang für eine Eingangsspannung, die höher ist als die Erfassungsschwelle, und einen zweiten logischen Zustand am Ausgang für eine Eingangsspannung liefert, die niedriger ist als die Erfassungsschwelle.

8. Kipposzillator nach Anspruch 7, **dadurch gekennzeichnet, daß** die Ausgangsstufe eine erste Spannungsschwelle tief/hoch (V1) und eine zweite Spannungsschwelle hoch/tief (V2) aufweist.

**Claims**

1. Integrated circuit of the type having a substrate or well of a first doping type (P) and in this substrate or well:

- a first doping diffusion of a second type (N$^+$) in the form of a bar (1) of length Lb and width e, provided at its two ends (2, 3) with first (A) and second (B) connection terminals;
- a polysilicon sheet (4) which entirely covers the bar (1) with the exception of the connection terminals and having an extension which forms a third connection terminal (D);
- a second doping diffusion (5) of the second type (N$^{++}$) auto-aligned by the polysilicon sheet (4) and provided with a fourth connection terminal (F);

the integrated circuit thus made up forming a quadripole A, B, D, F of the type with a resistor, capacitor and transistor.

2. Integrated circuit according to Claim 1, **characterised in that** the bar (1) is linear.

3. Integrated circuit according to Claim 1, **characterised in that** the bar (1) is wound in a helix.

4. Integrated circuit according to Claim 1, **characterised in that** the bar (1) is folded in a coil.

5. Integrated circuit according to Claim 1, **characterised in that** the bar (1) is less doped (N$^+$) than the auto-aligned (N$^{++}$) diffusion (5).

6. Method of manufacturing an integrated circuit in a substrate or well of a first doping type, **characterised in that** it includes the following steps:

- the production of a bar of non auto-aligned diffusion of a second type (1);
- the formation of a gate oxide in an aperture wider than the bar, delimited by thick oxide;
- the production of a polysilicon sheet (4) which entirely covers the diffusion bar with the exception of the connection terminals;
- the production of a diffusion of the second type (5), this diffusion being auto-aligned by the polysilicon sheet and delimited by the thick oxide;
- the connection of each end of the bar to a first connection terminal A and to a second connection terminal B;
- the connection of the auto-aligned diffusion to a third connection terminal (F);
- the connection of a fourth connection terminal (D) to the polysilicon sheet;

in order to form a quadripole A, B, D, F of the type with a resistor, capacitor and

7. Relaxation oscillator having:

- a quadripole A, B, D, F according to Claim 1;

- a load transistor Tp put in series between a charging voltage Vcc and the terminal A of the quadripole, with its gate connected to the terminal D of the quadripole;

- an output stage DET with at least one detection threshold, having its input connected to the terminal B of the quadripole and its output OUT connected to the terminal D of the quadripole;

this output stage supplying a first logic state as an output for an input voltage greater than the detection threshold and a second logic state as an output for an input voltage less than the detection threshold.

8. Relaxation oscillator according to Claim 7, **characterised in that** the output stage has a first low/high voltage threshold (V1) and a second high/low voltage threshold (V2).

FIG_1a

FIG_1b

FIG_1c

a)

SiO$_2$

P

b)

nitrure de silicium

SiO$_2$

P

c)

Oxyde de champ

P

d)

e)

4

5    1    3    5

f)

Oxyde mince   4

Isolation
(vapox)

Métal

N$^{++}$   N$^{++}$   N$^{++}$

P   1   5   3   1

FIG_2

FIG_3

FIG_4

EP 0 626 728 B1